# EUROPEAN PATENT SPECIFICATION

(11) **EP 0 982 980 B1**
(45) Date of publication and mention of the grant of the patent: **05.03.2003**
(21) Application number: 99116413.8
(22) Date of filing: 20.08.1999
(51) Int. Cl.: H05K 13/00

(54) **Control device for and method of controlling a linear drive mechanism**
Steuervorrichtung und Verfahren zum Steuern eines Linearantriebes
Dispositif de commande et procédé pour commander un entrainement linéaire

(30) Priority: 20.08.1998 JP 23448598
(43) Date of publication of application: 01.03.2000
(73) Proprietor: YAMAHA HATSUDOKI KABUSHIKI KAISHA, Iwata-shi Shizuoka-ken (JP)
(72) Inventor: Takafumi, Ito, Iwata-shi, Shizuoka-ken (JP)
(74) Representative: Grünecker, Kinkeldey, Stockmair & Schwanhäusser Anwaltssozietät

(56) References cited:
- PATENT ABSTRACTS OF JAPAN vol. 1995, no. 01, 28 February 1995 (1995-02-28) & JP 06 296097 A (MATSUSHITA ELECTRIC IND CO LTD), 21 October 1994 (1994-10-21)

## Description

This invention relates to a control device for a linear drive mechanism, said linear drive mechanism having a moving frame respective parts of which are separately drivable by a pair of motors, said control device comprising a control unit adapted to correct velocity instructions for said motors to ensure a substantially unique drive of said motors, and to a method of controlling a linear drive mechanism, said linear drive mechanism having a moving frame respective parts of which are separately driven by a pair of motors, whereas velocity instructions for said motors are corrected to ensure a substantially unique drive of said motors.

The linear drive mechanism has been used in machines in various fields in which a moving frame holding a working member is adapted to move in a given direction through a feed screw by means of a motor; for example, the loading machine for loading electronic parts on printed circuit boards as a machine equipped with such a kind of linear drive mechanism.

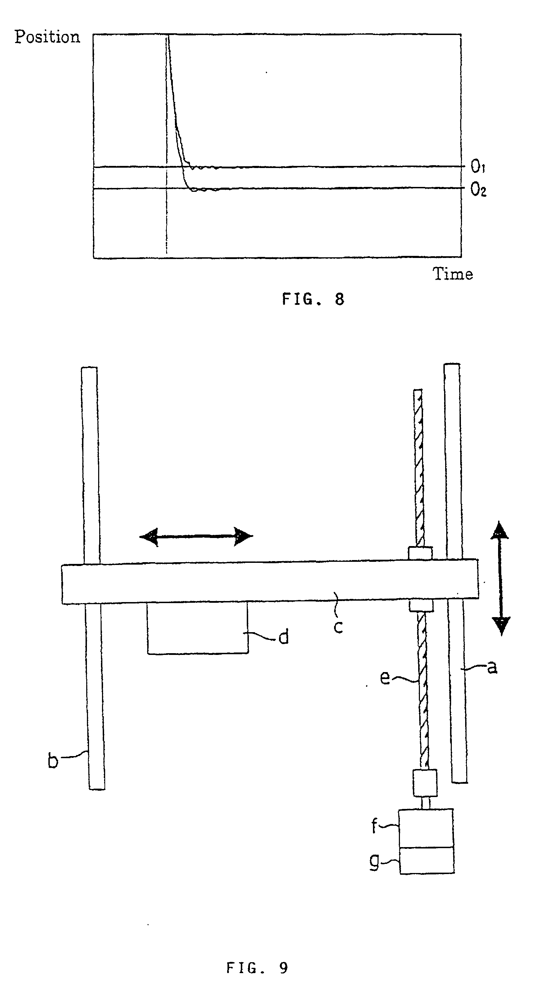

Fig. 9 schematically shows a structure of a typical conventional loading machine, which comprises a moving frame c extending in the direction of X-axis and supported at both ends on a pair of guide rails a, b on a body of the loading machine to be movable in the direction of Y-axis, and a head unit as a working member supported on the moving frame c for movement on the direction of X-axis. The head unit d is adapted to pick up electronic parts from a parts supply section to load the parts on printed circuit boards.

In the loading machine, a mechanism for driving the moving frame c comprises a ball screw shaft (feed screw) e disposed in the direction of Y-axis, at one end (on the side of the guide rail a) and downwardly of the moving frame c, and a servo-motor f coupled to the ball screw shaft e; the ball screw shaft e is fitted in a nut section provided at one end of the moving frame; and rotation of the ball screw shaft e driven by the servo-motor f causes the moving frame c to move in the direction of Y-axis. The servo-motor f is provided with an encoder g; the servo-motor f and encoder g are connected to a control unit (not shown); and the control unit is adapted to control the operation of the servo-motor f.

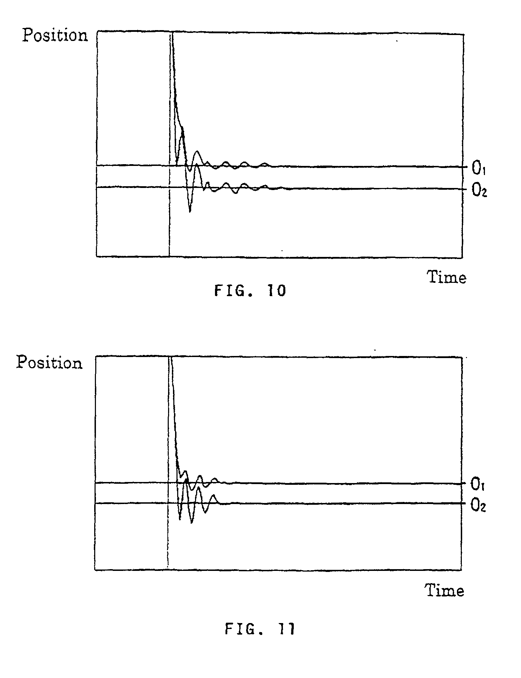

In the case of the single sided drive in which a feed screw is coupled at one end of a moving frame c as described above, when the moving frame c is moved to a target position and decelerated for stopping, the movement of one end (driven side: the side at which the ball screw shaft e is coupled) of the moving frame c and that of the other end thereof (follower side) are as shown in Fig. 10. That is, residual vibrations remain on the driven and the follower sides of the moving frame c, respectively, after the target positions O_{M}, O_{S} have been reached, and the residual vibration on the follower side is larger and longer on account especially of deflection, etc. of the moving frame c. Therefore, if loading of parts on the printed circuit board is performed before the residual vibrations have decayed sufficiently, loading accuracy will be decreased, while if loading is performed after the residual vibrations have decayed sufficiently since the moving frame c reached the target position, to ensure loading accuracy, the efficiency of loading work will be lowered.

Regarding alternative example of the drive mechanism of the moving frame, although a system of a double sided drive type has been used in which a pair of ball screw shafts and a pair of servo-motors for driving said ball screw shafts are provided and the moving frame is driven at both ends simultaneously, it is difficult even for such a double sided drive type to suppress the residual vibrations sufficiently if the servo-motors are simply controlled separately, as described later (see Fig. 11).

Thus, Japanese Unexamined Patent Publication Hei 6-296097, for example, has suggested a loading machine comprising a pair of feed nuts at both ends of X table (moving frame), a pair of feed screws fitted in the feed nuts, and a pair of motors for separately driving the pair of feed screws, wherein a co-operative control section is provided in a control system for the pair of motors to suppress the vibration of the X table.

That is, the control system of this loading machine has a pair of servo-drivers for respectively driving the motors, a pair of velocity instruction sections for sending velocity instructions to the respective servo-drivers based on signals and information of target positions from encoders provided in the motors, and a cooperative control section for comparing acceleration values of the pair of feed nuts determined from signals from encoders to output the corresponding correction signals to the pair of velocity instruction sections, and corrects the velocity instructions such that the difference between the acceleration values is eliminated.

In the loading machine shown in Japanese Patent publication referred to above, separate velocity instructions are sent from a pair of velocity instruction sections to a pair of servo-drivers while the velocity instructions are corrected in response to the acceleration difference, therefore structure of the control system is complicated in that, for example, servo-drivers and velocity instruction sections should be provided in pairs, respectively. In addition, if the velocity instructions are corrected, current supply to the motors is controlled for correction indirectly through the corresponding changes of the current instruction values, therefore control response is likely to be slower.

Accordingly, it is an objective of the present invention to provide a control device for and a method of controlling a linear drive mechanism in which a drive system for a moving frame is of a double sided drive type using a pair of motors, operation of the pair of motors can be controlled for regulation such that the vibration of the moving frame is suppressed, the structure of the control system is relatively simple, and corrective control for vibration suppression can be performed with high response.

According to the present invention, this objective is solved for a control device as indicated above in that said control unit comprising current instruction corrective means for determining current instruction values based on a comparison between one velocity instruction generated and a velocity of one motor and the velocity difference between said motors for supplying both motors with respective currents.

In order to fruther enhance the operation, it is advantageous when said control device comprising a pair of current control means for respectively controlling drive currents of said pair of motors, a pair of detection means for detecting driving states of said motors to provide data with respect to the position and velocity, current instruction generating means connected with said current instruction corrective means and one current control means for determining current instruction values based on said comparison between said one of said velocity instruction values and said velocity of the corresponding motor.

In that case, it is advantageous when said control device comprises a velocity instruction generating means for determining velocity instruction values based on a comparison between a positioning instruction value and a position of each of said motors, the output of said velocity instruction generating means being supplyable to said current instruction generating means.

Further, it is possible that said control device further comprising velocity difference calculation means connected with the current instruction corrective means for calculating a velocity difference between said pair of motors based on outputs of said detection means, whereas the current instruction values are supplyable to said current control means such that they are differentiable in response to the velocity difference calculatable by said velocity difference calculation means.

Although a hugh variety of driving means are known and possible, it is advantageous when said control device is adapted to control the moving frame by means of rotating feed screws fittable in unit sections provided at both ends of said moving frame, said feed screws being rotatable by said motors.

According to the present invention, this objective is solved for a method as indicated above in that current instruction values are determined based on a comparison between one generated velocity instruction and a velocity of one motor and a velocity difference between said motors and supplying both motors with respective currents.

In that case, it is possible to separately control the drive currents of said motors with the respective current instruction values, detecting the drive states of each motor to provide data with respect to the position and velocity, determining current instruction values based on a comparison between one of velocity instruction values generated and said velocity of the corresponding motor.

In order to receive data for controlling said linear mechanism, it is advantageous when the velocity difference is calculated by using the data of the drive status, whereas the current instruction values are supplied such that they are differentiable in response to the calculated velocity difference.

One advantageous embodiment of the invention is a control device for a linear drive mechanism having a moving frame supported for linear movement on guides extending in a predetermined direction, a working member held on said moving frame, a pair of feed screws fitted in nut sections provided at both ends of the moving frame in a direction perpendicular to the moving direction thereof, a pair of motors for separately driving said feed screws, and a pair of current control means for respectively controlling drive currents of said pair of motors, wherein said control device for a linear drive mechanism comprises a pair of detection means for detecting driving states of said motors to provide data with respect to the position and velocity; velocity instruction generating means for determining velocity instruction values base on a comparison between a positioning instruction value and a position of each of said motors;
current instruction generating means for determining current instruction values based on a comparison between one of said velocity instruction values and a velocity of the corresponding motor to respectively output said current instruction values to said pair of current control sections; calculation means for calculating a velocity difference between said pair of motors based on outputs of said detection means;
and current instruction corrective means for correcting the current instruction values supplied to said current control sections such that they are differentiated in response to the velocity difference calculated by said calculation means.

In this device, the moving frame is driven by a pair of motors through feed screws, the pair of motors are controlled through the velocity instruction generating means, current instruction generating means, and the pair of current control means, and when velocity difference is produced between the pair of motors, current instruction values are corrected so as to regulate motor drive currents such that the velocity difference is diminished, thereby suppressing the vibration of the moving frame. Especially, despite of relatively simple structure of the control system, regulation of the motor drive currents in response to the velocity difference, can be performed with high response, thus enhancing a function of suppressing sliding movement of the moving frame.

The above described linear drive mechanism is a device mounted, for example, on a loading machine for loading electronic parts on printed circuit boards, wherein said linear drive mechanism comprises a head unit as a working member, with a parts suction nozzle, for picking up the electronic parts from parts supply sections, said head unit being held on the moving frame for movement in the direction of X-axis; said moving frame is supported on a body of the loading machine for movement in the direction of Y-axis; and a pair of feed screws fitted in the nut sections provided at both ends of the moving frame in the direction of X-axis, extend in the direction of Y-axis in parallel to each other, said pair of feed screws being driven by a pair of motors, respectively.

Therefore, if this invention is applied to a loading machine, when electronic parts are loaded on a printed circuit board, vibration of the moving frame during deceleration for stopping is suppressed and the length of time taken for the moving frame to be at rest, is decreased, thus effecting improved loading accuracy as well as reduced tact time.

Other preferred embodiments of the present invention are laid down in further dependent claims.

In the following, the present invention is explained in greater detail with respect to several embodiments thereof in conjunction with the accompanying drawings, wherein:
Fig. 1 is a schematic plan view showing an example of a loading machine embodying the present invention;
Fig. 2 is a front view of a section of the loading machine carrying a head unit;
Fig. 3 is a schematic drawing of the moving frame drive section in the loading machine;
Fig. 4 is a block diagram showing the structure of the control system;
Fig. 5 is a illustration showing a physical model of the inertia system;
Fig. 6 is a block diagram of the inertia system;
Fig. 7 is a block diagram of the inertia system, as being controlled by the control system in Fig. 4;
Fig. 8 is a graph showing the movement of both ends of the moving frame at the time it is decelerated for stopping;
Fig. 9 is schematic drawing of the moving frame drive section of a typical conventional loading machine;
Fig. 10 is a graph showing the movement of the moving frame at the time it is decelerated for stopping, in a typical conventional construction shown in Fig. 9; and
Fig. 11 is a graph showing the movement of the moving frame at the time it is decelerated for stopping, in another conventional construction.

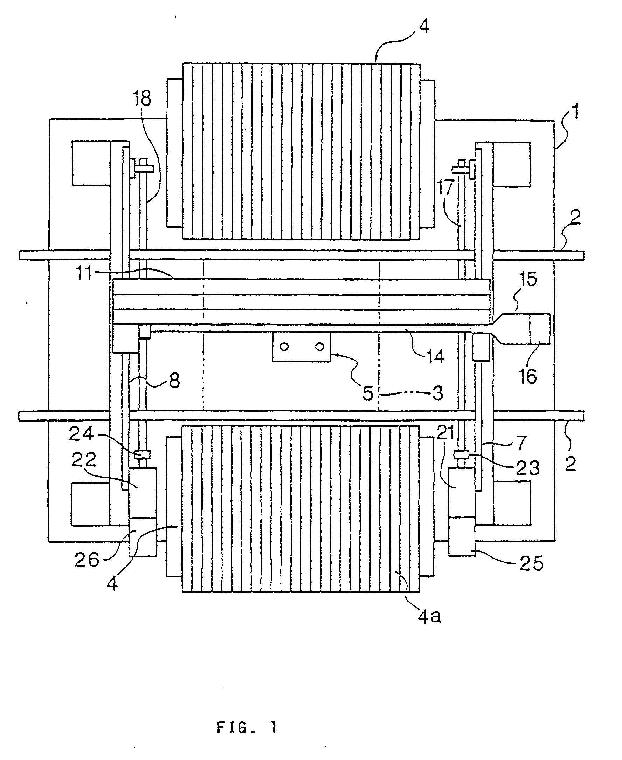

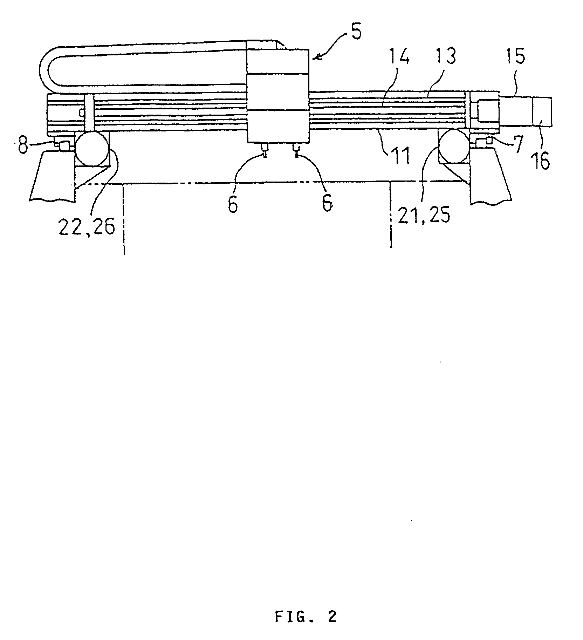

Fig. 1 and Fig. 2 show a loading machine as an example of a machine equipped with a linear drive mechanism embodying the present invention. In these figures, on a base 1 of the body of the loading machine is disposed a conveyer 2 for transporting printed circuit boards, and a printed circuit board 3 is transported on the conveyer 2 to be held at a predetermined substrate locating position. At the sides of the conveyer 2 are disposed parts supply sections 4, which are provided with feeders for supplying electronic parts, for example, multiple lines of tape feeders 4a.

Upwardly of the base 1 is mounted a head unit 5 as a working member. The head unit 5 is a device for picking up electronic parts from the parts supply sections to load them on the printed circuit board 3, and provided with one or plurality of section nozzle(s) 6, a Z-axis drive mechanism (not shown) for lifting the suction nozzle(s) 6, and R-axis drive mechanism (not shown) for rotating the suction nozzle(s) 6, etc.

This head unit 5 is held on a moving frame 11 for movement in the direction of X-axis (direction parallel to the conveyer 2), and the moving frame 11 is supported on the body of the loading machine for movement in the direction of Y-axis (direction perpendicular to the X-axis on a horizontal plane). The movement of the moving frame 11 in the direction of Y-axis and that of the head unit 5 in the direction of X-axis relative to the moving frame 11, allows the head unit 5 to move in the directions of X- and Y-axes with respect to the body of the loading machine, across the parts supply sections 4 and the parts loading section where the printed circuit board 3 is located.

That is, on the base 1 are disposed a pair of linear guides 7, 8 extending in the direction of Y-axis and spaced at a given distance in the direction of X-axis, on which is supported the moving frame 11 at both ends thereof for movement along the guides 7, 8. The moving frame 11 is formed to be longer in the direction of X-axis; on the moving frame 11 are provided a guide member 13 in the direction of X-axis, a feed screw in the direction of X-axis or a ball screw shaft 14, and a X-axis servo-motor 15 for driving the ball screw 14; on the guide member 13 is held the head unit 5 for movement; and a nut section (not shown) provided in the head unit is fitted on the ball screw shaft 14. With the ball screw shaft 14 being driven by the X-axis servo-motor 15 to be rotated, the head unit 5 is adapted to move in the direction of X-axis. Numeral 16 designates an encoder attached to the X-axis servo-motor 15.

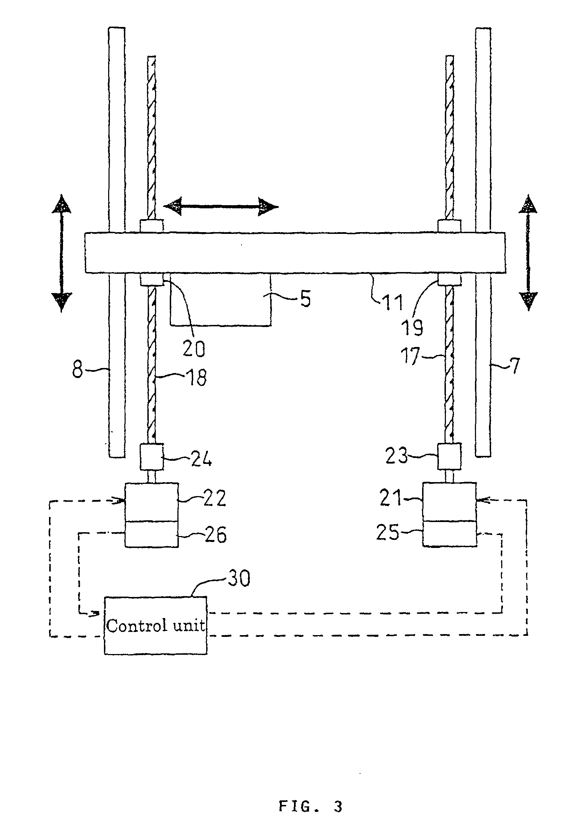

Regarding the mechanism for driving the moving frame 11, feed screws in the direction of Y-axis and motors for driving the feed screws are provided in pairs, respectively. That is, as showing Fig. 3 as a schematic drawing, feed screws in the direction of Y-axis or a pair of ball screw shafts 17, 18 are disposed at both ends and downwardly of the frame 11 in the vicinity of the guides 7, 8, extending in the direction of Y-axis in parallel to each other. The ball screw shafts 17, 18 are fitted in nut sections 19, 20 provided at both ends of the moving frame 11, respectively. A pair of Y-axis servo-motors 21, 22 are coupled to the ball screw shafts 17, 18 through couplings 23, 24, respectively.

To the Y-axis servo- motor 21, 22 are attached encoders 25, 26 as detection means for detecting the driving states of the motors to provide data with respect to the position and velocity. The Y-axis servo- motors 21, 22 and encoders 25, 26 are connected to a control unit 30.

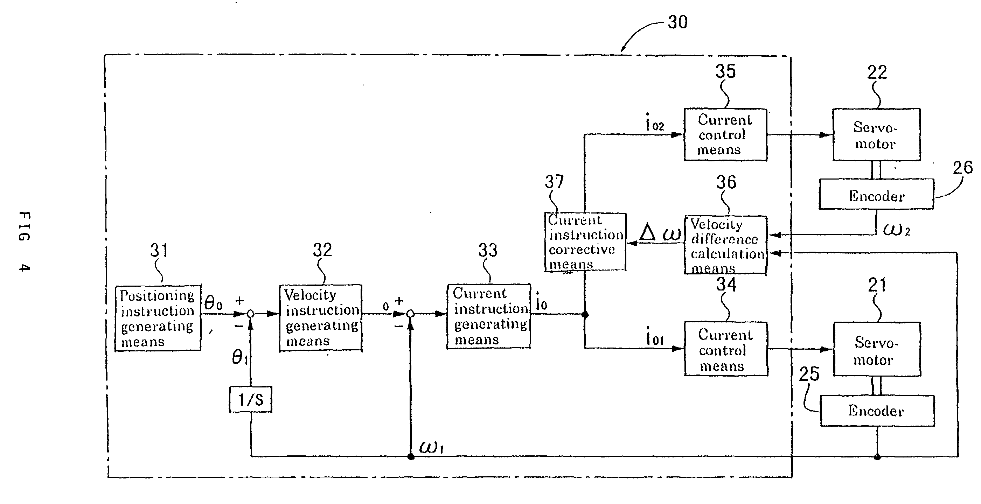

The structure of a control system for the Y-axis servo-motors 21, 22 will be described with reference to Fig. 4. In the following description, one of the Y-axis servo-motors 21, 22 are referred to as a first motor 21 and the other a second motor 22.

The control system shown in Fig. 4 comprises, in the control unit 30, positioning instruction generating means 31, velocity instruction generating means 32, current instruction generating means 33, first and second current control means 34, 35, velocity difference calculation means 36, and current instruction corrective means 37. To the control unit 30 are sent, from encoders 25, 26, detected signals of the rotational velocity of the motors 21, 22.

The positioning instruction generating means 31 determines a target position at every certain minute time interval to output a positioning instruction value according to the control pattern set in response to the distance to be traveled by the moving frame 11. The velocity instruction generating means 32 compares the positioning instruction value θ₀, with the detected position value θ₁ obtained by integration of the detected velocity value outputted from the encoder 25 attached to the first motor, and outputs a velocity instruction value ω₀ in response to the difference therebetween to regulate the velocity such that the actual position is brought closer to the instructed one. The current instruction generating means 33 compares the velocity instruction value ω₀ with the detected velocity value ω₁ outputted from the encoder 25 and outputs a current instruction value i₀ in response to the difference therebetween to regulate the drive current of the motor such that the actual velocity is brought closer to the instructed one.

The current control means 34, 35 controls the drive currents of motors 21, 22 in response to the current instruction values, respectively. Although detailed illustration of the current control is omitted, a current feedback control, for example, is performed in which the current actually supplied to each motor is detected, the detected current value and the current instruction value are compared, and current supply to the motor is controlled such that the two current values coincide with each other.

in this case, the first current control means 34 controls the drive current of the first motor 21 in response to the current instruction value i₀₁, (=i₀) supplied from the current instruction generating means 33, while the second current control means 35 controls the drive current of the second motor in response to the current instruction value i₀₂ corrected by the current instruction corrective means 37.

The velocity difference calculation means 36 calculates the velocity difference Δ ω which is a difference between the detected velocity value ω₁ outputted from the encoder 25 attached to the first motor 21 and the detected velocity value ω₂ outputted from the encoder 26 attached to the second motor 22. The current instruction corrective means 37 corrects the current instruction value supplied to the second current control section such that the current instruction values supplied to the current control sections are differentiated in response to the velocity difference Δ ω calculated by the velocity difference calculation means 36.

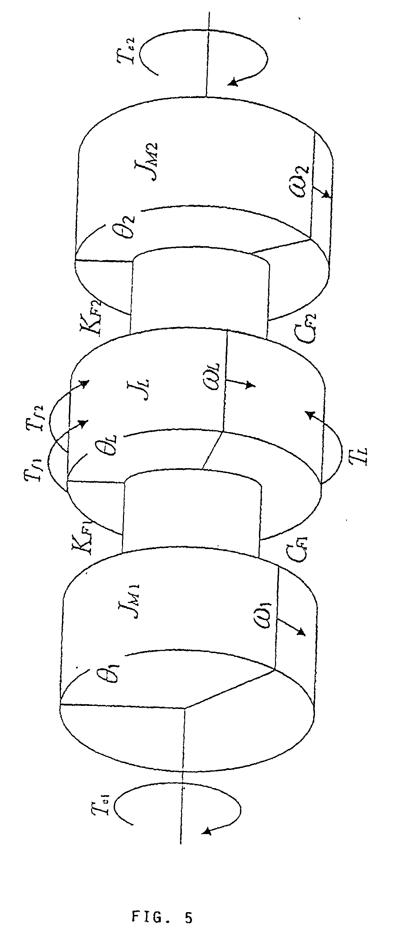

Functions of the foregoing device in the present embodiment will be described with reference to Fig. 5-Fig.

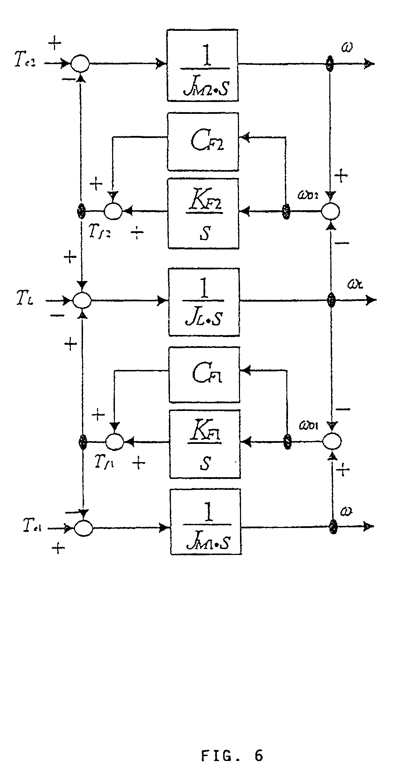

Fig. 5 shows a physical model of a three-inertia system composed of two motors and one load, where a load (head unit, etc.) is driven by a pair of motors. Fig. 6 shows a block diagram of such a three-inertia system.

Symbols in the figures are as follows:
- Tₑ₁:: Source torque of the first motor
- Tₑ₂:: Source torque of the second motor
- T_{f1}:: Axial torque by the first motor
- T_{f2}:: Axial torque by the second motor
- T_{L}:: Disturbance torque
- J_{M1}:: Inertia of the first motor
- J_{M2}:: Inertia of the second motor
- J_{L}:: Inertia of the load
- θ₁:: Angular displacement of the first motor
- θ₂:: Angular displacement of the second motor
- θ_{L}:: Displacement of the load
- ω₁:: Angular velocity of the first motor
- ω₂:: Angular velocity of the second motor
- ω_{L}:: Velocity of the load
- K_{F1}:: Spring constant between first motor and load
- K_{F2}:: Spring constant between second motor and load
- C_{F1}:: Viscous damping coefficient between first motor and load
- C_{F2}:: Viscous damping coefficient between second motor and load
- s:: Laplace operator

As shown in these figures, the difference between the source torque Tₑ₁ and the axial torque T_{f1}, of the first motor 21, and the inertia J_{M1} of the first motor 21, determine the velocity ω₁ of the first motor, and likewise, the difference between the source torque Tₑ₂ and the axial torque T_{f2} of the second motor 22, and the inertia J_{M2} of the second motor 22, determine the velocity ω₂ of the second motor. On the load (moving frame 11 and head unit 5) are exerted axial torques T_{f1}, T_{f2} caused by the first and second motors 21, 22 and the disturbance torque T_{L}, and these torques T_{f1}, T_{f2}, T_{L} and the inertia J_{L} of the load, determine the velocity ω_{L} of the load.

The axial torque T_{f1} caused by the first motor 21 is determined by the difference between the velocity ω₁ of the first motor 21 and the velocity ω_{L} of the load, and the spring constant K_{F1} and viscous damping coefficient CF1 between the first motor and the load. Likewise, the axial torque T_{f2} caused by the second motor 22 is determined by the difference between the velocity ω₂, of the second motor 22 and the velocity ω_{L} of the load, and the spring constant K_{F2} and viscous damping coefficient C_{F2} between the second motor and the load.

Thus, even if the first and the second motor 21, 22 are identical in their dimensions and the torques Tₑ₁, Tₑ₂ are the same value, when the spring constants K_{F1}, K_{F2} or viscous damping coefficients C_{F1}, C_{F2} are different from each other between the first motor and the load and between the second motor and the load, depending on the location of the head unit 5 on the moving frame 11, the axial torques T_{f1}, T_{f2} will vary, thus differentiates the velocities ω₁, ω₂, of the motors 21, 22. Alternatively, the variation of the inertia, etc. of the motors will produce a difference between the velocities ω₁, ω₂ of the motors 21, 22.

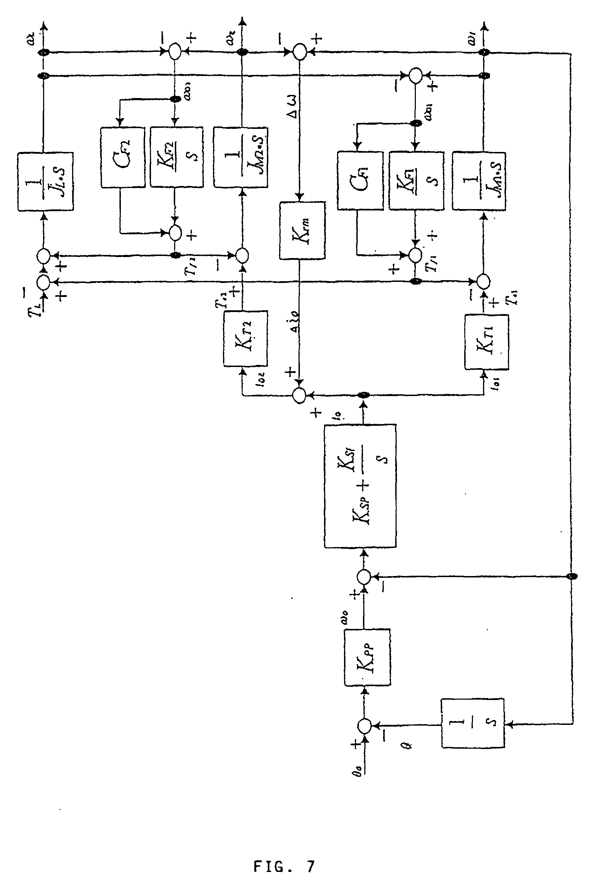

Fig. 7 shows a block diagram of the inertia system as shown in Fig. 6, as being controlled by the control system shown in Fig. 4.

As shown in the figure, in this control system, the difference between the positioning instruction value θ₀ and the detected position value θ₁ is multiplied by a predetermined positional loop gain KPP to calculate the velocity instruction value ω₀ through the velocity instruction means 32, and conversion is made through the current instruction means 33 to determine the current instruction value i₀ using the velocity loop proportional gain K_{SP} and the velocity loop integral gain K_{S1} on the basis of the velocity instruction value ω₀ and the detected velocity value ω₁. Then, to the first current control means 34 is supplied the current instruction value i₀₁ (=i₀), which is multiplied by the torque constant K_{T1} of the first motor 21 to provide the source torque Tₑ₁ of the first motor 21.

On the other hand, through the current instruction corrective means 36, the velocity difference Δω between the first and second motors 21, 22 is multiplied by a predetermined gain Kᵣₘ to calculate the current instruction corrective value Δi₀, which is added to the current instruction value i₀ to determine the current instruction value i₀₂ for the second current control means 34. The current instruction value i₀₂ multiplied by the torque constant K_{T2} is the source torque Tₑ₂ of the second motor 22.

In this way, the electric current and the source torque of the second motor 22 are regulated in response to the velocity difference Δω such that, for example, when the velocity ω₂ of the second motor 22 is smaller than the velocity ω₁ of the first motor (when the velocity difference Δω > 0), the electric current and the source torque of the second motor 22 are greater, thus reducing the velocity difference Δω between both motors 21, 22.

As a result of the above described control, the movement of one end of the moving frame 11 (the side driven by the first motor 21) and that of the other end (the side driven by the second motor 22) at the time the moving frame 11 is moved to a target position for stopping, are as shown in Fig. 8. As seen from the figure, the residual vibrations are reduced significantly compared to the conventional system, and the length of time taken for the moving frame to reach the target positions O₁, O₂ for rest, is decreased to a great extent.

That is, in the case of the single sided drive type which is a typical conventional construction as described above, the residual vibrations are greater as shown in Fig. 10 because of the deflection of the moving frame, etc., and it takes a considerable length of time for the frame to be at rest. Further, even if the drive system is of a double sided drive type, without provision of the velocity calculation means 36 and the current instruction corrective means 37 shown in Fig. 4, the difference in the spring constants K_{F1}, K_{F2} or viscous damping coefficients C_{F1}, C_{F2}, between the motor and the load, creates the velocity difference between both motors 21, 22, which causes relative displacement between positions of both ends of the moving frame 11, thus preventing adequate suppression of the residual vibration. On the contrary, in the device of this invention incorporating the velocity difference calculation means 36 and corrective means 37, the velocity difference between both motors 21, 22 can be rectified, thus suppressing the residual vibration effectively.

In addition, in the device of this invention, correction is performed in response to the velocity difference Δω between both motors 21, 22 and after determination of the current instruction value through the current instruction generating means 33, therefore the velocity instruction generating means 32 and the current instruction generating means 33 are used in common to a pair of motors 21, 22 and only the current control means 34, 35 are provided separately for the motors 21, 22, so that the structure of the control system can be simpler than that of a system as disclosed in the foregoing Japanese Unexamined Patent Publication Hei 6-296097 in which the velocity difference is calculated, and the velocity instruction generating means and the servo- driver are provided separately for the motors. Further, since the current instruction values defining the drive currents of the motors are corrected directly in response to the velocity difference Δω, control response is improved compared to the system as shown in the foregoing Patent Publication in which the velocity instruction values are corrected.

It is to be understood that the device of the present invention is not limited to a loading machine given in the above described embodiment, but can be applied to an orthogonal robot, etc.

As described above, according to the invention, a moving frame holding a working member is driven by a pair of motors through a pair of feed screws; the pair of motors are controlled by velocity instruction generating means, current instruction generating means, and a pair of current control means; and further provided are calculation means for calculating the velocity difference between the pair of motors, and current instruction corrective means for correcting current instruction values supplied to the current control sections such that they are differentiated in response to the velocity difference calculated by the calculation means. Therefore, the structure of the control system is relatively simple, while the motor drive currents can be controlled for correction with good response when the velocity difference is produced, thus enhancing vibration suppression effects at the time of the moving frame being decelerated for stopping.

Among others, when this invention is applied to a loading machine for loading electronic parts on printed circuit boards, improved loading accuracy and reduced tack time can be effected.

## Claims

1. Control device for a linear drive mechanism, said linear drive mechanism having a moving frame (11) respective parts of which are separately drivable by a pair of motors (21,22), said control device comprising a control unit (30) adapted to correct velocity instructions for said motors (21,22) to ensure a substantially unique drive of said motors (21,22), **characterized in that** said control unit (30) comprising current instruction corrective means (37) for determining current instruction values (i₀₁, i₀₂) based on a comparison between one velocity instruction generated and a velocity (ω₁) of one motor (21) and the velocity difference (Δω) between said motors (21,22) for supplying both motors (21,22) with respective currents.

2. Control device according to claim 1, **characterized by** a pair of current control means (34,35) for respectively controlling drive currents of said pair of motors (21,22), a pair of detection means (25,26) for detecting driving states of said motors (21,22) to provide data with respect to the position and velocity, current instruction generating means (33) connected with said current instruction corrective means (37) and one current control means (34) for determining current instruction values based on said comparison between said one of said velocity instruction values and said velocity (ω₁) of the corresponding motor (21).

3. Control device according to claim 2, **characterized by** a velocity instruction generating means (32) for determining velocity instruction values based on a comparison between a positioning instruction value and a position of each of said motors (21,22), the output of said velocity instruction generating means (32) being supplyable to said current instruction generating means (33).

4. Control device according to claim 2 or 3, **characterized by** velocity difference calculation means (36) connected with the current instruction corrective means (37) for calculating a velocity difference between said pair of motors (21,22) based on outputs of said detection means (25,26), whereas the current instruction values are supplyable to said current control means (34,35) such that they are differentiable in response to the velocity difference calculatable by said velocity difference calculation means (36).

5. Control device according to claim 3 or 4, **characterized by** a positioning instruction generating means (31) connected with the velocity instruction generating means (32) for generating data to position said moving frame (11).

6. Control device according to at least one of the preceding claims 1 to 5, **characterized in that** it is adapted to control the moving frame (11) by means of rotating feed screws (17,18) fittable in unit sections (19,20) provided at both ends of said moving frame (11), said feed screws (17,18) being rotatable by said motors (21,22).

7. Use of the control device according to at least one of the preceding claims 1 to 6 for a loading machine for loading electronic parts on printed circuit boards which comprises a head unit (5) as a working member, a parts suction nozzle (6), for picking up the electronic parts from parts supply sections (4), said head unit (5) being held on the moving frame (11) for movement in the direction of X-axis; said moving frame (11) is supported on a body of the loading machine for movement in the direction of Y-axis; and a pair of feed screws (17,18) fitted in nut sections (19,20) provided at both ends of the moving frame (11) in the direction of X-axis, extend in the direction of Y-axis in parallel to each other, said pair of feed screws (17,18) being driven by the pair of motors (21,22), respectively.

8. Method of controlling a linear drive mechanism, said linear drive mechanism having a moving frame (11) respective parts of which are separately driven by a pair of motors (21,22), whereas velocity instructions for said motors (21,22) are corrected to ensure a substantially unique drive of said motors (21,22), **characterized in that** current instruction values (i₀₁, i₀₂) are determined based on a comparison between one generated velocity instruction and a velocity (ω₁) of one motor (21) and a velocity difference (Δω) between said motors (21,22) and supplying both motors (21,22) with respective currents.

9. Method according to claim 8, **characterized by** separately controlling the drive currents of said motors (21,22) with the respective current instruction values (i_{01,} i₀₂₎, detecting the drive states of each motor (21,22) to provide data with respect to the position and velocity, determining current instruction values based on a comparison between one of velocity instruction values generated and said velocity (ω₁) of the corresponding motor (21).

10. Method according to claim 9, **characterized in that** the velocity instruction values are determined by comparing a position instruction value and a position of each of the motors (21,22).

11. Method according to claim 9 or 10, **characterized in that** the velocity difference is calculated by using the data of the drive status, whereas the current instruction values are supplied such that they are differentiable in response to the calculated velocity difference.

12. Method according to claim 10 or 11, **characterized in that** data is generated to position the moving frame (11).

13. Method according to at least one of the preceding claims 8 to 12, **characterized in that** said method being adapted to control a loading machine for loading electronic parts on printed circuit boards, which comprises a head unit (5) as a working member, a parts suction nozzle (6), for picking up the electronic parts from parts supply sections (4), said head unit (5) being held on the moving frame (11) for movement in the direction of X-axis; said moving frame (11) is supported on a body of the loading machine for movement in the direction of Y-axis; and a pair of feed screws (17,18) fitted in nut sections (19,20) provided at both ends of the moving frame (11) in the direction of X-axis, extend in the direction of Y-axis in parallel to each other, said pair of feed screws (17,18) being driven by the pair of motors (21,22), respectively.

## Patentansprüche

1. Steuervorrichtung für eine Linearantriebsvorrichtung, wobei die Linearantriebsvorrichtung einen Bewegungsrahmen (11) hat, dessen jeweilige Teile durch ein Paar Motoren (21, 22) separat antreibbar sind, wobei die Steuervorrichtung eine Steuereinheit (30) aufweist, vorgesehen für genaue Geschwindigkeitsvorgaben für die Motoren (21, 22), um einen im wesentlichen gleichen Antrieb der Motoren (21, 22) zu sichern, **dadurch gekennzeichnet, dass** die Steuereinheit (30) die Strombefehls- Korrektureinrichtung (37) aufweist, um Strombefehlswerte (i₀₁, i₀₂) auf der Grundlage eines Vergleiches zwischen einer erzeugten Geschwindigkeitsbefehl und einer Geschwindigkeit (ω₁) eines Motors (21) und dem Geschwindigkeitsunterschied (Δω) zwischen den Motoren (21, 22) zu bestimmen, zum Versorgen beider Motoren (21, 22) mit jeweiligen Strömen.

2. Steuervorrichtung nach Anspruch 1, **gekennzeichnet durch** ein Paar von Stromsteuereinrichtungen (34, 35) zum jeweiligen Steuern der Antriebsströme des Motorpaares (21, 22), ein Paar von Erfassungseinrichtungen (25, 26) zum Erfassen der Antriebszustände der Motoren (21, 22), um Daten in Bezug zu der Position und der Geschwindigkeit bereitzustellen, eine Strombefehls- Erzeugungseinrichtung (33), verbunden mit der Strombefehls- Korrektureinrichtung (37) und eine Stromsteuereinrichtung (34) zum Bestimmen von Strombefehlswerten auf der Grundlage des Vergleichs zwischen dem einen der Geschwindigkeitsbefehlswerte und der Geschwindigkeit (ω₁) des entsprechenden Motors (21).

3. Steuervorrichtung nach Anspruch 2, **gekennzeichnet durch** eine Geschwindigkeitsbefehls- Erzeugungseinrichtung (32) zum Bestimmen der Geschwindigkeitsbefehlswerte auf der Grundlage eines Vergleichs zwischen einem Positionierungsbefehlswert und einer Position jedes der Motoren (21, 22), wobei das Ausgangssignal der Geschwindigkeitsbefehls- Erzeugungseinrichtung (32) zu der Strombefehls- Erzeugungseinrichtung (33) zuführbar ist.

4. Steuervorrichtung nach Anspruch 2 oder 3, **gekennzeichnet durch** eine Geschwindigkeitsunterschied- Berechnungseinrichtung (36), verbunden mit der Strombefehls- Korrektureinrichtung (37) zur Berechnung eines Geschwindigkeitsunterschiedes zwischen dem Motorpaar (21, 22) auf der Grundlage von Ausgangssignalen der Erfassungseinrichtung (25, 26), während die Strombefehlswerte zu den Stromsteuereinrichtungen (34, 35) derart zuführbar sind, dass sie differenzierbar sind, in Abhängigkeit von dem Geschwindigkeitsunterschied, der **durch** die Geschwindigkeitsdifferenz- Berechnungseinrichtung (36), berechenbar ist.

5. Steuervorrichtung nach Anspruch 3 oder 4, **gekennzeichnet durch** eine Positionierungsbefehls- Erzeugungseinrichtung (31), verbunden mit der Geschwindigkeitsbefehls- Erzeugungseinrichtung (32) zum Erzeugen von Daten, um den Bewegungsrahmen (11) zu positionieren.

6. Steuervorrichtung nach zumindest einem der vorhergehenden Ansprüche 1 bis 5, **dadurch gekennzeichnet, dass** sie angepasst ist, um den Bewegungsrahmen (11) mittels der Rotationsvorschubspindeln (17, 18), einsetzbar in die Einheitsabschnitte (19, 20), die an beiden Enden des Bewegungsrahmens (11) vorgesehen sind, zu steuern, wobei die Rotationsvorschubspindeln (17, 18) durch die Motoren (21, 22) drehbar sind.

7. Verwendung der Steuervorrichtung nach zumindest einem der vorhergehenden Ansprüche 1 bis 6 für eine Bestückungsmaschine zum Bestücken elektronischer Teile auf gedruckte Leiterplatten, die eine Kopfeinheit (5) als ein Arbeitsteil aufweisen, eine Teile- Ansaugdüse (6) zum Aufnehmen der elektronischen Teile von Teile- Zuführabschnitten (4), wobei die Kopfeinheit (5) auf dem Bewegungsrahmen (11) zur Bewegung in die Richtung der X- Achse gehalten wird; wobei der Bewegungsrahmen (11) auf einem Rahmen der Bestückungsmaschine zur Bewegung in die Richtung der Y- Achse gelagert ist; und ein Paar von Vorschubspindeln (17, 18), eingesetzt in die Mutternabschnitte (19, 20), vorgesehen an beiden Enden des Bewegungsrahmens (11) in Richtung der X- Achse, die sich in die Richtung der Y- Achse parallel zueinander erstrecken, wobei das Paar von Vorschubspindeln (17, 18) jeweils durch das Motorpaar (21, 22) angetrieben wird.

8. Verfahren zur Steuerung einer Linearantriebsvorrichtung, die einen Bewegungsrahmen (11) hat, dessen jeweilige Teile durch ein Paar von Motoren (21, 22) separat angetrieben werden, wobei Geschwindigkeitsbefehle für die Motoren (21, 22) korrigiert werden, um einen im wesentlichen gleichen Antrieb der Motoren (21, 22) zu sichern, **dadurch gekennzeichnet, dass** die Strombefehlswerte (i₀₁, i₀₂) auf der Grundlage eines Vergleiches zwischen einem erzeugten Geschwindigkeitsbefehls und einer Geschwindigkeit (ω₁) eines Motors (21) und einem Geschwindigkeitsunterschied (Δω) zwischen den Motoren (21, 22) erzeugt werden und beide Motoren (21, 22) mit den jeweiligen Strömen versorgt werden.

9. Verfahren nach Anspruch 8, **gekennzeichnet durch** separates Steuern der Antriebströme des Motors (21, 22) mit den jeweiligen Strombefehlswerten (i₀₁, i₀₂), Erfassen der Antriebszustände jedes Motors (21, 22), um Daten in Bezug zu der Position und der Geschwindigkeit zu schaffen, Bestimmen von Strombefehlswerten auf der Grundlage eines Vergleichs zwischen einem der erzeugten Geschwindigkeitsbefehlswerte und der Geschwindigkeit (ω₁) des entsprechenden Motors (21).

10. Verfahren nach Anspruch 9, **dadurch gekennzeichnet, dass** die Geschwindigkeitsbefehlswerte durch Vergleich eines Positionsbefehlswertes und einer Position jedes der Motoren (21, 22) bestimmt werden.

11. Verfahren nach Anspruch 9 oder 10, **dadurch gekennzeichnet, dass** der Geschwindigkeitsunterschied durch Gebrauch der Daten des Antriebsstatus berechnet wird, während die Strombefehlswerte so bereitgestellt werden angewandt sind, dass sie in Abhängigkeit von dem berechneten Geschwindigkeitsunterschied unterscheidbar sind.

12. Verfahren nach Anspruch 10 oder 11, **dadurch gekennzeichnet, dass** Daten zum Positionieren des Bewegungsrahmens (11) erzeugt werden.

13. Verfahren nach zumindest einem der Ansprüche 8 oder 12, **dadurch gekennzeichnet, dass** das Verfahren vorgesehen ist, eine Bestückungsmaschine zum Bestücken elektronischer Teile auf gedruckte Schaltkreise zu steuern, die eine Kopfeinheit (5) als ein Arbeitsteil aufweist, eine Teile- Ansaugdüse (6) zum Aufnehmen der elektronischen Teile von Teile- Zuführabschnitten (4), wobei die Kopfeinheit (5) auf dem Bewegungsrahmen (11) zur Bewegung in der Richtung der x- Achse gehalten wird; der Bewegungsrahmen (11) auf einem Rahmen der Bestückungsmaschine zur Bewegung in Richtung der Y- Achse gelagert wird; und ein Paar von Vorschubspindeln (17, 18), eingesetzt in Mutterabschnitte (19, 20), vorgesehen an beiden Enden des Bewegungsrahmens (11) in der Richtung der X- Achse, sich in die Richtung der Y- Achse parallel zueinander erstrecken, wobei das Paar von Vorschubspindeln (17, 18) jeweils durch das Paar von Motoren (21, 22) angetrieben wird.

## Revendications

1. Dispositif de commande destiné à un mécanisme d'entraînement linéaire, ledit mécanisme d'entraînement linéaire comportant un châssis mobile (11) dont des parties respectives peuvent être entraînées séparément par une paire de moteurs (21, 22), ledit dispositif de commande comprenant une unité de commande (30) adaptée pour corriger des instructions de vitesse destinées aux dits moteurs (21, 22), afin d'assurer un entraînement essentiellement unique desdits moteurs (21, 22), **caractérisé en ce que** ladite unité de commande (30) comprend des moyens de correction d'instruction de courant (37) destinés à déterminer des valeurs d'instruction de courant (i₀₁, i₀₂) sur la base d'une comparaison entre une instruction de vitesse générée et une vitesse (ω₁) d'un moteur (21 et la différence de vitesse (Δω) entre lesdits moteurs (21, 22), afin de fournir des courants respectifs aux deux moteurs (21, 22).

2. Dispositif de commande selon la revendication 1, **caractérisé par** une paire de moyens de commande de courant (34, 35) destinée à commander respectivement des courants d'entraînement de ladite paire de moteurs (21, 22), une paire de moyens de détection (25, 26) destinés à détecter des états d'entraînement desdits moteurs (21, 22), afin de fournir des données par rapport à la position et à la vitesse, des moyens générateurs d'instruction de courant (33) connectés aux dits moyens de correction d'instruction de courant (37) et un moyen de commande de courant (34) destiné à déterminer des valeurs d'instruction de courant sur la base de ladite comparaison entre ladite valeur de l'une desdites valeurs d'instruction de vitesse et ladite vitesse (ω₁) du moteur correspondant (21).

3. Dispositif de commande selon la revendication 2, **caractérisé par** des moyens générateurs d'instruction de vitesse (32) destinés à déterminer des valeurs d'instruction de vitesse sur la base d'une comparaison entre une valeur d'instruction de positionnement et une position de chacun desdits moteurs (21, 22), la sortie desdits moyens générateurs d'instruction de vitesse (32) pouvant s'appliquer aux dits moyens générateurs d'instruction de courant (33).

4. Dispositif de commande selon la revendication 2 ou la revendication 3, **caractérisé par** des moyens de calcul de différence de vitesse (36) connectés aux moyens de correction d'instruction de courant (37) destinés à calculer une différence de vitesse entre ladite paire de moteurs (21, 22) sur la base de sorties desdits moyens de détection (25, 26), alors que les valeurs d'instruction de courant peuvent s'appliquer aux dits moyens de commande de courant (34, 35) de sorte qu'elles peuvent être différenciées en réponse à la différence de vitesse qui peut être calculée par lesdits moyens de calcul de différence de vitesse (36).

5. Dispositif de commande selon la revendication 3 ou la revendication 4, **caractérisé par** des moyens générateurs d'instruction de positionnement (31) connectés aux moyens générateurs d'instruction de vitesse (32), afin de générer des données destinées à positionner ledit châssis mobile (11).

6. Dispositif de commande selon au moins l'une des revendications précédentes 1 à 5, **caractérisé en ce qu'**il est adapté pour commander le châssis mobile (11) au moyen de vis de commande en rotation (17, 18) pouvant être ajustées dans des sections d'ensemble (19, 20) disposées aux deux extrémités dudit châssis mobile (11), lesdites vis de commande (17, 18) pouvant être mises en rotation par lesdits moteurs (21, 22).

7. Utilisation du dispositif de commande selon au moins l'une des revendications précédentes 1 à 6 destiné à une machine de chargement destinée à déposer des pièces électroniques sur des cartes à circuit imprimé qui comprend une tête (5) en tant qu'élément de fonctionnement, une buse d'aspiration des pièces (6) destinée à la reprise de pièces électroniques à partir de sections d'alimentation en pièces (4), ladite tête (5) étant maintenue sur le châssis mobile (11), afin de se déplacer dans le sens d'un axe X ; ledit châssis mobile (11) est en support sur un corps de la machine de chargement afin de se déplacer dans le sens d'un axe Y ; et une paire de vis de commande (17, 18) ajustées dans des sections à écrou (19, 20) aménagées aux deux extrémités du châssis mobile (11) dans le sens de l'axe X, s'étendent dans le sens de l'axe Y en parallèle l'une par rapport à l'autre, ladite paire de vis de commande (17, 18) étant respectivement entraînée par la paire de moteurs (21, 22) .

8. Procédé de commande d'un mécanisme d'entraînement linéaire, ledit mécanisme d'entraînement linéaire comportant un châssis mobile (11) dont des parties respectives peuvent être entraînées séparément par une paire de moteurs (21, 22), alors que des instructions de vitesse destinées aux dits moteurs (21, 22) sont corrigées, afin d'assurer un entraînement essentiellement unique desdits moteurs (21, 22), **caractérisé en ce que** des valeurs d'instruction de courant (i₀₁, i₀₂) sont déterminées sur la base d'une comparaison entre une instruction de vitesse générée et une vitesse (ω₁) d'un moteur (21) et une différence de vitesse (Δω) entre lesdits moteurs (21, 22) et sont fournies aux deux moteurs (21, 22) avec des courants respectifs.

9. Procédé selon la revendication 8, **caractérisé par** une commande séparée des courants d'entraînement desdits moteurs (21, 22), lesdites valeurs d'instruction de courant respectives (i₀₁, i₀₂) détectant les états d'entraînement de chaque moteur (21, 22), afin de fournir des données par rapport à la position et à la vitesse, de déterminer des valeurs d'instruction de courant sur la base d'une comparaison entre l'une des instructions de vitesse générées et ladite vitesse (ω₁) du moteur correspondant (21).

10. Procédé selon la revendication 9, **caractérisé en ce que** les valeurs d'instruction de vitesse sont déterminées par une comparaison entre une valeur d'instruction de position et une position de chacun des moteurs (21, 22).

11. Procédé selon la revendication 9 ou la revendication 10, **caractérisé en ce que** la différence de vitesse est calculée en utilisant les données de l'état d'entraînement, alors que les valeurs d'instruction de courant sont fournies, de telle sorte qu'elles peuvent être différenciées en réponse à la différence de vitesse calculée.

12. Procédé selon la revendication 10 ou la revendication 11, **caractérisé en ce que** des données sont générées, afin de positionner le châssis mobile (11).

13. Procédé selon au moins l'une des revendications précédentes 8 à 12, **caractérisé en ce que** ledit procédé est adapté pour commander une machine de chargement destinée à déposer des pièces électroniques sur des cartes à circuit imprimé, qui comprend une tête (5) en tant qu'élément de fonctionnement, une buse d'aspiration des pièces (6) destinée à la reprise de pièces électroniques à partir de sections d'alimentation en pièces (4), ladite tête (5) étant maintenue sur le châssis mobile (11) afin de se déplacer dans le sens d'un axe X ; ledit châssis mobile (11) est en support sur un corps de la machine de chargement, afin de se déplacer dans le sens d'un axe Y ; et une paire de vis de commande (17, 18) ajustées dans des sections à écrou (19, 20) aménagées aux deux extrémités du châssis mobile (11) dans le sens d'un axe X, s'étendent dans le sens d'un axe Y en parallèle l'une par rapport à l'autre, ladite paire de vis de commande (17, 18) étant respectivement entraînée par la paire de moteurs (21, 22).
